# EUROPEAN PATENT SPECIFICATION

(11) **EP 3 889 958 B1**
(45) Date of publication and mention of the grant of the patent: **10.09.2025**
(21) Application number: 20167281.3
(22) Date of filing: 31.03.2020
(51) Int. Cl.: G10L 21/0364, G10L 25/48, G06F 16/683, H03G 5/16, G10H 1/12, H03G 5/00, H04R 3/00

(54) **DYNAMIC AUDIO PLAYBACK EQUALIZATION USING SEMANTIC FEATURES**
ENTZERRUNG VON DYNAMISCHER AUDIOWIEDERGABE UNTER VERWENDUNG SEMANTISCHER MERKMALE
ÉGALISATION DE LECTURE AUDIO DYNAMIQUE À L'AIDE DE CARACTÉRISTIQUES SÉMANTIQUES

(43) Date of publication of application: 06.10.2021
(73) Proprietor: Moodagent A/S, 1120 Copenhagen K (DK)
(72) Inventor: Steffensen, Peter Berg, DK-1120 Copenhagen K (DK); Henderson, Mikael, DK-1120 Copenhagen K (DK); Jensen, Nick, 1120 Copenhagen K (DK)
(74) Representative: Nordic Patent Service A/S

(56) References cited:
- US-A1- 2007 064 954
- US-A1- 2008 075 303
- US-A1- 2017 070 817
- US-A1- 2017 230 024
- US-A1- 2019 206 423
- HYOUNG-GOOK KIM ET AL: "Car audio equalizer system using music classification and loudness compensation", ICT CONVERGENCE (ICTC), 2011 INTERNATIONAL CONFERENCE ON, IEEE, 28 September 2011 (2011-09-28), pages 553 - 558, XP032011368, ISBN: 978-1-4577-1267-8, DOI: 10.1109/ICTC.2011.6082659

## Description

### TECHNICAL FIELD

The disclosure relates to digital audio signal processing. In particular, the embodiments described herein relate to methods and systems for optimizing audio playback using dynamic equalization of media content, such as music files, based on semantic features.

### BACKGROUND

As computer technology has improved, the digital media industry has evolved greatly in recent years. Users are able to use electronic devices such as mobile communication devices (e.g., cellular telephones, smartphones, tablet computers, etc.) to consume music, video and other forms of media content. For instance, users can listen to audio content (e.g., music) or watch video content (e.g., movies, TV broadcasts, etc.) on a variety of electronic devices.

At the same time, advances in network technology have increased the speed and reliability with which information can be transmitted over computer networks. It is therefore possible for users to stream media content over computer networks. Online media streaming services exploit these possibilities by allowing users to browse and consume large collections of media content using their electronic devices.

Users may listen to, watch, or otherwise receive and consume media content optimized for a variety of contexts. For example, it is common to listen to music while driving, riding public transit, exercising, hiking, doing chores, or the like, which circumstances may all require differently optimized audio playback based on the acoustic characteristics of the environment. In addition, the experience and acoustic presentation of different types of sound files may further benefit from different audio settings. For example, audio books should be optimized for speech or vocal settings, and pop music should be optimized to give a boost to the bass and the treble. Furthermore, different people have different preferences when it comes to listening to an audio signal, for example some people prefer an enhanced bass or treble, while others prefer more natural or "flat" settings.

An efficient method for accommodating to these different circumstances of media content consumption is the dynamic equalization of media content at playback.

Equalization is a method for enlarging a sound field by amplifying a specified value in a frequency domain. Generally, equalizers modify an audio file by dividing an audio band into sub-bands. The equalizers are classified into graphic equalizers and parametric equalizers based on their structure. Operations of both kinds of equalizer are commonly set by three parameters, which are mean frequency, bandwidth, and a level variation. In a graphic equalizer, mean frequency and bandwidth are fixed and only the level can be adjusted, which makes graphic equalizers widely used in media players for manual adjustments. In a parametric equalizer, the three parameters can be adjusted independently, therefore making manual adjustment difficult.

The most general method of setting an equalizer is by manually setting the equalizer setting information, wherein a user can adjust a level with respect to each frequency by moving a tab or slider. However, since this operation has to be performed for each piece of music, it is troublesome. In addition, it is difficult for a user to adequately set an equalizer without knowledge of the music and its different features.

Another general method of setting an equalizer involves selecting equalizer setting information in a pre-set equalizer list, wherein a user selects one of many pre-set equalizer information settings, which is thought to be suitable for the piece of music to be listened to, thereby setting the equalizer. Although this method is more less troublesome than the previous method, this method still requires user manipulation.

There also exist some solutions for automatic equalization of audio playback. One of these solutions is based on reading genre or other metadata information recorded in an audio file header and performing equalization corresponding to the metadata when an audio file is reproduced. In this case, although user manipulation is not needed, audio files are adjusted by an associated metadata, which is most often manually associated and linked to the whole discography or a whole album of an artist, and therefore may not be a true representation of the individual media content's properties.

Another approach for automatic equalization is based on analyzing the audio signal itself and determining certain physical characteristics, such as sound pressure level (SPL), for selecting an optimal equalization curve or filter to apply. These approaches are mostly designed based on psychoacoustics, e.g. to compensate for nonlinear increase of loudness perception at low frequencies as a function of playback level, wherein a partial loss of low frequency components compared to other frequencies is reported when a media content is played back at a lower level, that can be balanced by amplifying the low frequency ranges.

Prior art document "Car audio equalizer system using music classification and loudness compensation" (HYOUNG-GOOK KIM ET AL, ICTC 2011) describes an automatic equalizer system controlled by the integration of a musical genre classification and loudness compensation in an automobile stereo player. The musical genre is classified based on content analysis of the musical segment detected from the audio stream, and the musical sound is boosted with the given frequency gains based on the musical genre and loudness compensation when played back. US 2017/070817 A1 discloses the adaptation of an equalizer depending on the genre determined for the input audio signal. The genre is determined using extracted features and/or metadata associated with the audio input. US 2008/075303 A1 describes the analysis of audio streams in order to determine the music genre based on a classifier. The equalizer mode is then selected depending on the determined music genre. US 2007/064954 A1 discloses the determination of audio characteristics (rhythm, chord progression, etc) based on audio signal analysis and/or metadata. Sound profile is selected to best fit the audio characteristics.

These approaches, while providing a more dynamic automatic equalization on a track-by-track level, still rely on low-level physical features derived from the audio signal and therefore cannot take into account the content (e.g. mood) of media file and the context of its playback.

Accordingly, there is a need for a method and system for automatic, dynamic playback equalization of media content that can take into account high-level semantic characteristics of the media content as well as contextual information regarding the playback environment.

### SUMMARY

It is an object to provide a method and system for dynamic playback equalization of media content using a computer-based system and thereby solving or at least reducing the problems mentioned above. The foregoing and other objects are achieved by the features of the independent claims. Further implementation forms are apparent from the dependent claims, the description and the figures.

According to a first aspect, there is provided a computer-implemented method for optimizing audio playback on a device, the device comprising an audio interface and at least one auxiliary sensor configured to generate a sensor signal comprising information regarding at least one of noise level, temperature, location, acceleration, lighting, type of the device, operation system running on the device, or biometric data of a user of the device, the method comprising:
receiving an audio signal and at least one feature vector associated with the audio signal, the feature vector comprising a plurality of feature values, each of the plurality of feature values representing a semantic characteristic of the audio signal;
receiving at least one sensor signal from the at least one auxiliary sensor;
determining at least one frequency response profile for the audio signal based on the at least one feature vector and at least one sensor signal using a set of rules between the feature values, the sensor signals, and certain frequency ranges of the frequency response profile respectively;
applying the at least one frequency response profile to the audio signal to produce an equalized audio signal; and playing the equalized audio signal through the audio interface.

This method enables automatic, dynamic playback equalization of audio signals of media content items, which can take into account high-level semantic characteristics of individual media content items, such as a mood or genre determined specifically for the media content item in question. The use of feature vectors for determining a frequency response profile provides an option for also considering other input information, for example contextual information regarding the playback environment, as a factor for the equalization.

In a possible implementation form of the first aspect the device comprises a storage medium, and determining the at least one frequency response profile comprises:
providing at least one predefined frequency response profile stored in the storage medium; and
selecting at least one of the predefined frequency response profiles based on the at least one feature vector, using a predefined set of rules between the feature values and certain predefined frequency response profiles.

In a further possible implementation form of the first aspect the frequency response profile is divided into a plurality of frequency response bands, each frequency response band associated with a range of frequencies between two predefined limits *L1, L2* corresponding to the audible frequency spectrum; wherein determining the at least one frequency response profile comprises:
assigning a variable to each frequency response band,
wherein a value of each variable defines a frequency response (output-input ratio of amplification) of the assigned frequency response band;
adjusting the variables based on the at least one feature vector, wherein each variable value is associated with one or more feature values of the feature vector; and determining the frequency response profile based on values of assigned variables for each respective frequency response band.

In a further possible implementation form of the first aspect the audio signal comprises a plurality of audio segments, at least one of the audio segments having associated therewith a feature vector, the feature vector comprising feature values representing a semantic characteristic of the respective audio segment; and the method comprises
determining a frequency response profile for each audio segment based on at least one of
   - a feature vector associated with the respective audio segment,
   - a feature vector associated with a closest audio segment to the respective audio segment with an associated feature vector, or
   - a feature vector determined based on interpolation between feature vectors associated with closest audio segments before and after the respective audio segment with associated feature vectors;
applying the determined frequency response profile to each representative audio segment of the audio signal to produce a continuously equalized audio signal; and
playing the continuously equalized audio signal through the audio interface.

In a further possible implementation form of the first aspect determining the frequency response profile for each audio segment is further based on a composition profile, the composition profile being determined based on a chronological sequence of all feature vectors associated with the audio signal.

In a further possible implementation form of the first aspect the method comprises
receiving a playlist comprising a plurality of audio signals in a predefined order, each audio signal having associated therewith at least one feature vector; and
determining the at least one frequency response profile for one of the plurality of audio signals is based on at least one feature vector associated with a previous one of the plurality of audio signals in the playlist, in accordance with the predefined order.

In a further possible implementation form of the first aspect the method comprises:
receiving a set of audio signals, and a master feature vector associated with the set of audio signals, the master feature vector comprising a plurality of master feature values, each of the plurality of master feature values representing a semantic characteristic of the set of audio signals;
determining a master frequency response profile for the set of audio signals based on the master feature vector using a predefined set of rules between the master feature values and certain frequency ranges of the master frequency response profile;
applying the master frequency response profile to each of the audio signals within the set of audio signals instead or in combination with the determined at least one frequency response profile to produce a set of equalized audio signals; and
playing at least one equalized audio signal from the set of equalized audio signals through the audio interface.

In a further possible implementation form of the first aspect the master feature vector is determined based on a plurality or all associated feature vectors of the set of audio signals.

In a further possible implementation form of the first aspect the method further comprises:
receiving at least one additional, metadata-based feature vector associated with the received audio signal, the metadata-based feature vector comprising a plurality of metadata-based feature values, each of the plurality of metadata-based feature values representing a semantic characteristic of a metadata record associated with the audio signal; wherein
determining the at least one frequency response profile for the audio signal is further based on the metadata-based feature vector, using a predefined set of rules between the metadata-based feature values, the feature values, and certain predefined frequency response profiles.

In a further possible implementation form of the first aspect the semantic characteristic is one of
a perceived musical characteristic corresponding to a musical style, musical genre, musical sub-genre, rhythm, tempo, vocals, or instrumentation; or
a perceived emotional characteristic corresponding to a mood.

In a further possible implementation form of the first aspect the method further comprises:
detecting at least one user interaction between the device and a user of the device, the user interaction comprising at least one of playing, skipping, liking, disliking, repeating, rewinding, sharing (posting, tweeting) an audio signal, or adding an audio signal to a playlist;
determining a user profile vector associated with the user based on at least the detected user interactions; wherein
determining the frequency response profile is further based on a user profile vector associated with the user using a predefined set of rules between values of the user profile vector and certain frequency ranges of the frequency response profile.

In a further possible implementation form of the first aspect determining the user profile vector is further based on at least one of:
- aggregated semantic data correlating musical, emotional, and acoustic preferences of the user, the aggregated semantic data being determined from at least one of the feature vectors and the metadata-based feature vectors associated with audio signals, based on the detected user interactions,
- social profile vectors defined as user profile vectors of other users that are associated with the user based on social relationships; and
- aggregated sensor signals from an auxiliary sensor of the device configured to measure at least one of noise level, temperature, location, acceleration, lighting, type of the device, operation system running on the device, or biometric data of a user of the device.

In a further possible implementation form of the first aspect the device is further configured to change between a plurality of states, each state representing at least one predefined frequency response profile, wherein the device comprises at least one of
- a visual interface configured to provide visual feedback when the device changes to one of the plurality of states; and
- an audio interface configured to provide audio feedback when the device changes to one of the plurality of states;
and wherein the method further comprises changing the state of the at least one visual indicator according to the determined frequency response profile.

In a possible implementation form of the first aspect the number n of the plurality of feature values is 1 ≤ *n* ≤ 256, more preferably 1 ≤ *n* ≤ 100, more preferably 1 ≤ *n* ≤ 34; wherein each of the feature values is preferably an integer number, more preferably a positive integer number, most preferably a positive integer number with a value ranging from 1 to 7.

The inventors arrived at the insight that selecting the number of feature values and their numerical value from within these ranges ensures that the data is sufficiently detailed while also compact in data size in order to allow for efficient processing.

According to a second aspect, there is provided a computer-based system for optimizing audio playback, the system comprising:
a storage medium comprising a plurality of media content items, at least one feature vector associated with each of the media content items, each feature vector comprising a plurality of feature values, each of the plurality of feature values representing a semantic characteristic of the respective media content item;
at least one auxiliary sensor arranged in a device and configured to generate a sensor signal comprising information regarding at least one of noise level, temperature, location, acceleration, lighting, type of the device, operation system running on the device, or biometric data of a user of the device;
a database comprising a set of rules defining logical relationships between at least the feature values, the sensor signal, and certain frequency ranges of a frequency response profile respectively;
an audio signal processor configured to extract an audio signal from a media content item;
a processor configured to determine at least one frequency response profile for the audio signal based on the at least one associated feature vector and the sensor signal, using the set of rules;
an audio signal equalizer configured to produce an equalized audio signal based on an audio signal and at least one frequency response profile, according to the method steps of any one of the possible implementation forms of the first aspect; and
an audio interface configured to play the equalized audio signal.

According to a third aspect, there is provided a non-transitory computer readable medium storing instructions which, when executed by a processor, cause the processor of a computer-based system according to the second aspect to perform a method according to any one of the possible implementation forms of the first aspect.

Providing such instructions on a non-transitory computer readable medium enables users to download such instructions to their client device and achieve the advantages listed above without the need for any hardware upgrade of their device.

These and other aspects will be apparent from and the embodiment(s) described below.

### BRIEF DESCRIPTION OF THE DRAWINGS

In the following detailed portion of the present disclosure, the aspects, embodiments and implementations will be explained in more detail with reference to the example embodiments shown in the drawings, in which:
Fig. 1 shows a flow diagram of a method of optimizing audio playback in accordance with the first aspect using a device in accordance with the second aspect;
Fig. 2 shows a flow diagram of selecting a frequency response profile from predefined frequency response profiles in accordance with a possible implementation form of the first aspect;
Fig. 3 illustrates a frequency response profile determined by assigned variables in accordance with a further possible implementation form of the first aspect;
Fig. 4 illustrates the connection between feature values and variables in accordance with a further possible implementation form of the first aspect;
Fig. 5 shows a flow diagram of determining frequency response profiles of different audio segments of an audio signal in accordance with a further possible implementation form of the first aspect;
Fig. 6 shows a flow diagram of determining frequency response profiles of different audio signals in a playlist in accordance with a further possible implementation form of the first aspect;
Fig. 7 shows a flow diagram of producing a set of equalized audio signals using a master frequency response profile in accordance with a further possible implementation form of the first aspect;
Fig. 8 shows a flow diagram of producing an equalized audio signal using additional metadata-based feature vectors and sensor signals in accordance with a further possible implementation form of the first aspect;
Fig. 9 shows a flow diagram of producing an equalized audio signal using an additional user profile vector in accordance with a further possible implementation form of the first aspect;
Fig. 10 illustrates adjusting a device between a plurality of states according to frequency response profiles in accordance with a further possible implementation form of the first aspect; and
Fig. 11 shows a block diagram of a computer-based system in accordance with a possible implementation form of the second aspect.

### DETAILED DESCRIPTION

In various embodiments, a user 30 can interact with a device 20 such as a media player or mobile smartphone to browse and initiate playback of a media content item 22 such as an audio or video file. According to the various embodiments described below, a frequency response profile 4 is automatically determined and applied to the audio signal 1 of the media content item 22 to produce an equalized audio signal 7 for playback on the device 20 through an audio interface 26.

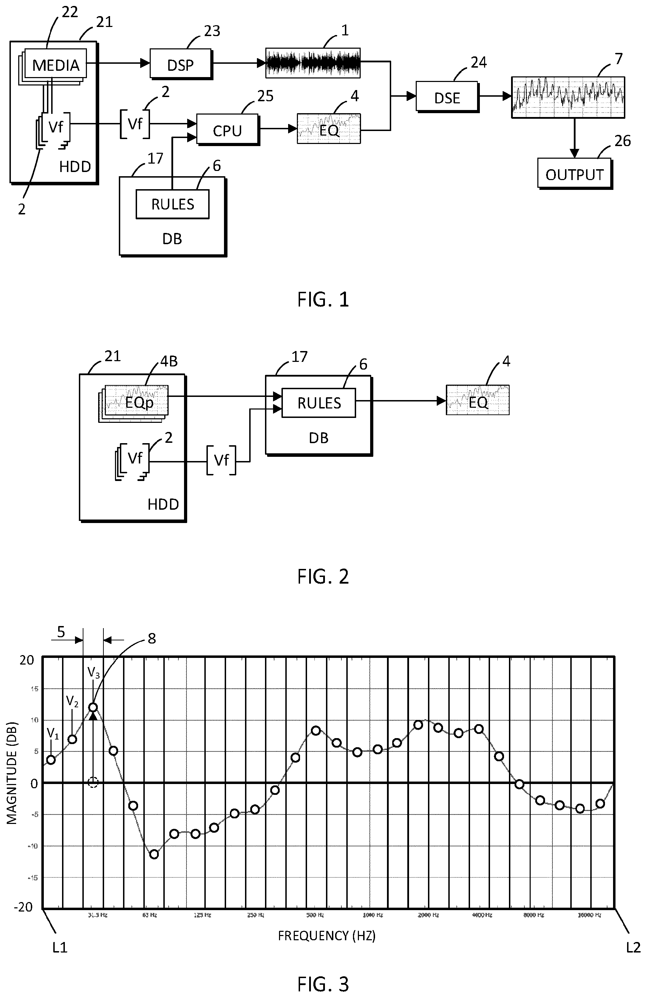

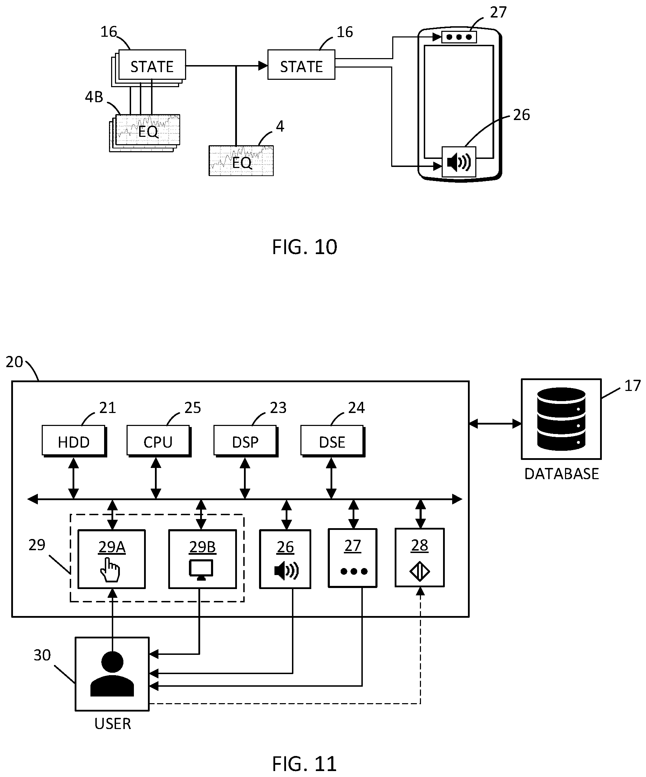

Fig. 1 shows a flow diagram of optimizing audio playback in accordance with the present disclosure, using a computer-based system such as for example the system shown on Fig. 11.

As will be described below in detail, the computer-based system comprises at least a storage medium 21, a database 17, an audio signal processor 23, a processor 25, an audio signal equalizer 24 and an audio interface 26.

The audio signal processor 23 and/or the audio signal equalizer 24 may be implemented as separate hardware modules or as software logic solutions implemented to run on the processor 25.

In some embodiments, all components of the computer-based system are implemented in a single device 20. In other possible embodiments, only some components are implemented as part of a single, user-facing device while other components are implemented in a host device connected to the user-facing device.

In some embodiments, the device 20 is a desktop computer. In some embodiments, the device 20 is portable (such as e.g. a notebook computer, tablet computer, or smartphone). In some embodiments, the device 20 is a smart speaker or virtual voice assistant. In some embodiments, the device 20 is user-wearable, such as a headset.

A plurality of media content items 22 are provided on the storage medium 21. The term 'media content items' in this context is meant to be interpreted as a collective term for any type of electronic medium, such as audio or video, suitable for storage and playback on a computer-based system. The storage medium 21 may be locally implemented in the device 20 or even located on a remote server, e.g. in case the media content items 22 are supported for the device 20 by an online digital music or movie delivery service (using an application program such as a Web browser or a mobile app through which a media content signal is streamed or downloaded into a local memory from the server of the delivery service over the Internet).

Each of the media content items 22 have associated therewith a feature vector [*V_{f}]* 2 comprising a number n of feature values 3, whereby each feature value 3 represents a semantic characteristic of the media content item 22 concerned.

A 'vector' in this context is meant to be interpreted in a broad sense, simply defining an entity comprising a plurality of values in a specific order or arrangement.

In the context of the present disclosure 'semantic' refers to the broader meaning of the term used in relation to data models in software engineering describing the meaning of instances. A semantic data model in this interpretation is an abstraction that defines how stored symbols (the instance data) relate to the real world, and includes the capability to express information that enables parties to the information exchange to interpret meaning (semantics) from the instances, without the need to know the meta-model itself.

Thus, the term 'semantic characteristic' is meant to refer to abstract high-level concepts (meaning) in the real world (e.g. musical and emotional characteristics such as a genre or mood of a music track), in contrast to low-level concepts (physical properties) such as sound pressure level (SPL) or Mel-Frequency Cepstral Coefficients (MFCC) that can be derived directly from an audio signal and represent no meaning in the real world. An important aspect of a semantic characteristic is furthermore the ability to reference a high-level concept without the need to know what high-level concept each piece of data (feature value) exactly represents. In practice this means that a feature vector 2 may comprise a plurality of feature values 3 that individually do not represent any specific high-level concept (such as mood or genre) but the feature vector 2 as a whole still comprises useful information regarding the relation of the respective media content items 22 to these high-level concepts which can be used for different purposes, such as comparing media content items 22 or optimizing playback of these media content items 22.

In a possible embodiment a feature value 3 may represent a perceived musical characteristic corresponding to the style, genre, sub-genre, rhythm, tempo, vocals, or instrumentation of the respective media content item 22 or a perceived emotional characteristic corresponding to the mood of the respective media content item 22. In further possible embodiments a feature value 3 may represent an associated characteristic corresponding to metadata, online editorial data, geographical data, popularity, or trending score associated with the respective media content item 22.

In an embodiment the number n of feature values 3 ranges from 1 to 256, more preferably from 1 to 100, more preferably from 1 to 34. Most preferably the number n of feature values 3 is 34.

In a preferred embodiment, the media content items 22 are musical segments, and each associated feature vector 2 consists of 34 feature values 3 corresponding to individual musical qualities of the respective musical segment. Each of these feature values 3 can take a discrete value from 1 to 7, indicating the degree of intensity of a specific feature, whereby the value 7 represents the maximum intensity and the value 1 represents the absence of that feature in the musical segment. The 34 feature values 3 in this exemplary embodiment correspond to a number of moods (such as 'Angry', 'Joy', or 'Sad'), a number of musical genres (such as 'Jazz', 'Folk', or 'Pop'), and a number of stylistic features (such as 'Beat Type', 'Sound Texture', or 'Prominent Instrument').

In a possible embodiment the feature values 3 of the feature vectors 2 for the media content items 22 may be determined by extracting the audio signal from each media content item 22 and subjecting the whole audio signal, or at least one of its representative segments, to a computer-based automated musical analysis process that comprise a machine learning engine pre-trained for the extraction of high-level audio feature values.

In a possible embodiment, a computer-based automated musical analysis process is applied for the extraction of high-level audio feature values 3 from an audio signal 1, wherein the audio signal 1 is processed to extract at least one low-level feature matrix, that is further processed using one or more pre-trained machine learning engines to predict a plurality of high-level feature values 3, which are then concatenated into a feature vector 2. This calculated feature vector 2 can be used alone, or in an arbitrary or temporally ordered combination with further feature vectors 2 calculated from different audio signals 1 extracted from the same media content items 22 (e.g. music track), as a compact semantic representation.

In an initial step, an audio signal 1 is extracted from a selected media content item 22 by an audio signal processor 23 or more commonly referred to as digital signal processor (DSP). In this context, 'audio signal' refers to any sound converted into digital form, where the sound wave (a continuous signal) is encoded as numerical samples in continuous sequence (a discrete-time signal). The audio signal may be stored in any suitable digital audio format, e.g., pulse code modulated (PCM) format. It may contain a single audio channel (e.g. the left stereo channel or the right stereo channel), a stereo audio channel, or a plurality of audio channels.

As illustrated, with the selection of a media content item 22, an associated feature vector 2 is also selected from the storage medium 21.

In a next step, a frequency response profile 4 is determined by a processor 25 for the audio signal 1 based on the associated feature vector 2, using a set of rules 6 defining logical relationships between at least the feature values 3 and certain frequency ranges of a frequency response profile 4. The rules are arranged in a database 17 which can be provided on a remote server or on a local storage of the device 20.

In this and the following embodiments, 'rules' are meant to refer to a broader sense of defined logical relationships between certain inputs and outputs, or determinate methods for performing a mathematical operation with certain inputs and obtaining a certain result. These rules 6 may be defined manually (e.g. based on observations and user feedback), may be calculated (e.g. using predefined equations), or may be obtained using supervised or unsupervised machine learning algorithms trained with a set of inputs and expected outputs.

In a next step, an equalized audio signal 7 is produced by an audio signal equalizer 24 which is configured to apply the frequency response profile 4 to the audio signal 1. The application of the frequency response profile 4 may happen using any known, conventional method of equalizing an audio signal and refers to the process of adjusting the balance between frequency components of the audio signal 1 by strengthening or weakening the energy (amplitude) of specific frequency bands or frequency ranges according to the determined frequency response profile 4.

Finally, the equalized audio signal 7 is forwarded for playback through an audio interface 26. In practice this means that the resulting equalized audio signal 7 is converted into analog form and then fed to an audio power amplifier which is driving a speaker (e.g., a loudspeaker or an earphone).

In a possible embodiment, as shown in Fig. 2, at least one predefined frequency response profile 4B is also stored in a storage medium 21. In this embodiment, for determining the at least one frequency response profile 4, a predefined frequency response profile 4B is selected for the selected media content item 2, based on its associated feature vector 2, using a predefined set of rules 6 between feature values 3 and the predefined frequency response profiles 4B.

The selected predefined frequency response profile 4B is then applied to the audio signal 1 by the audio signal equalizer 24 to produce the equalized audio signal 7 for playback, similarly as described above.

Fig. 3 illustrates a possible embodiment wherein the frequency response profile 4 is divided into a plurality of frequency response bands 5, each frequency response band 5 associated with a range of frequencies between two predefined limits *L1,* L2 corresponding to the audible frequency spectrum. In possible embodiments, the frequency response profile 4 may be divided into five, fifteen, thirty or even hundreds of frequency response bands 5, providing possibilities of varying granularity according to different use cases.

In a simple example, the frequency response profile 4 is divided into five frequency response bands 5 defined as follows:
1) Super Low = 20 Hz to 60 Hz
2) Lower Mids = 60 Hz to 250 Hz
3) Mids = 250 Hz to 1500 Hz
4) Upper Mids = 1500 Hz to 6600 Hz
5) Super High = 6600 Hz to 20,000 Hz

In this embodiment, a highly expressive emotional value defined in a feature vector 2 as "erotically passionate" can be mapped to the part of the frequency spectrum defined as "Super Low", which results in the associated frequency response band(s) 5 being amplified.

The frequency response profile 4 may be determined by assigning a variable 8 to each frequency response band, wherein a value of each variable 8 defines a frequency response output-input ratio of amplification of the assigned frequency response band 5. The variables 8 are adjusted based on the feature vector 2 associated with a selected media content item 22, using a predefined set of rules 6 between feature values 3 and variables 8. Thus, in this embodiment determining the frequency response profile 4 is based on values of assigned variables 8 for each respective frequency response band 5.

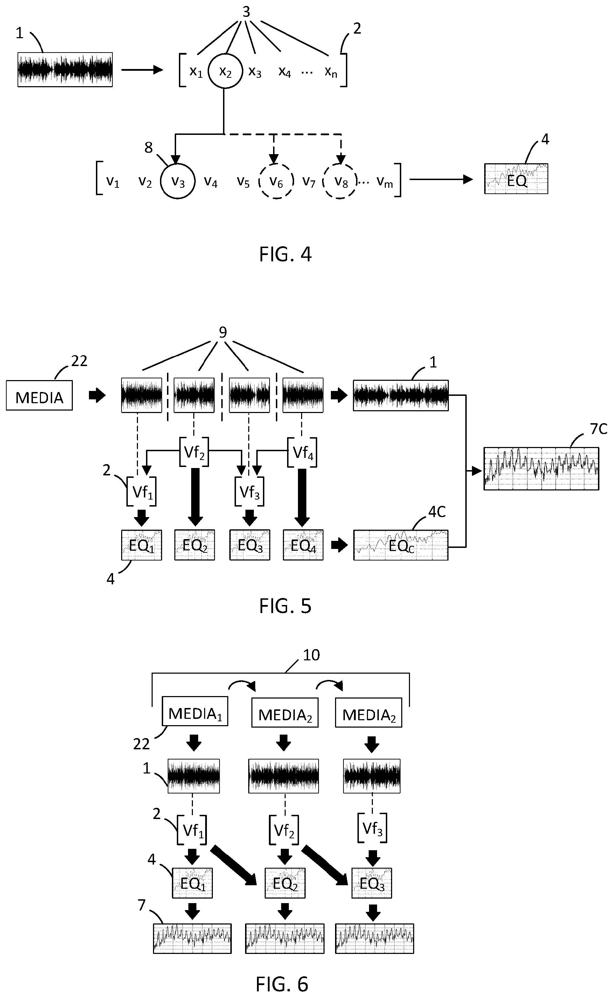

As illustrated in Fig. 4, each variable 8 value may be associated with one or more feature values 3 of the feature vector 2, therefore a feature value 3 of an associated feature vector 2 of a selected media content item 22 may affect only one variable 8, or multiple variables 8, for determining the frequency response profile 4.

In a possible embodiment, as shown in Fig. 5, the audio signal 1 derived from the media content item 22 can be divided into a plurality of audio segments 9, at least one of the audio segments 9 having associated therewith a feature vector 2 as described before, wherein feature values 3 of these feature vectors 2 represent a semantic characteristic of a respective audio segment 9. In such cases it may happen that a certain audio segments 9 does not have an associated feature vector 2, and therefore feature vectors 2 of other audio segments 9 may be used for determining a frequency response profile 4 for these audio segments 9. In particular, determining a frequency response profile 4 for each audio segment 9 may be based on either a feature vector 2 associated with the respective audio segment 9 (e.g. in the case of the second and fourth audio segments 9), a feature vector 2 associated with a closest audio segment 9 to the respective audio segment 9 with an associated feature vector 2 (e.g. in the case of the first audio segment 9), or a feature vector 2 determined based on interpolation between feature vectors 2 associated with closest audio segments 9 before and after the respective audio segment 9 with associated feature vectors 2 (e.g. in the case of the third audio segment 9).

For example, in case the musical and emotional characteristics and therefore feature vectors 2 of audio segments 9 vary sharply when moving from one "known" audio segment 9 (an audio segment 9 with an associated feature vector 2) to the next "known" audio segment 9, the sound field could be varied suddenly to generate unnatural sound, so it may be necessary to modify (smooth) the equalizer sequence. When using variables 8 as described above, variable 8 values corresponding to the same frequency band of two such "known" audio segments 9 that are different are interpolated to vary gradually to calculate variables 8 for the intermittent audio segments 9. A linear interpolation by the use of the mathematical expression *(V2-v1)*/*time* can be applied to variable values V1 and V2 corresponding to the same frequency response band 5 of the two "known" audio segments 9, wherein a time rate of the variable value is evaluated by dividing the difference between the equalizer variable value V1 in the first audio segment 9 and the equalizer variable value V2 in the second audio segment 9 by time, and variable values for the segments in between are calculated by the use of the time rate.

Once frequency response profiles 4 for each audio segment 9 are determined, the determined frequency response profile 4 may be applied to each representative audio segment 9 of the audio signal 1 to produce a continuously equalized audio signal 7C to be played through the audio interface 26 as described before.

In an embodiment, a composition profile 4C may be determined based on a chronological sequence of all feature vectors 2 associated with the audio signal 1 or determined for each audio segment 9 of the audio signal 1 as described above. This composition profile 4C may then be used for generating the equalized audio signal 7.

In an embodiment, the plurality of audio segments 9 are nonoverlapping, each audio segment 9 having a same predefined segment duration. This embodiment enables frame-by-frame continuous equalization of an audio signal 1.

In a possible embodiment, as shown in Fig. 6, instead of a single media content item 22 with a single audio signal 1, a playlist 10 comprising a plurality of media content item 22 in a predefined order are selected. From the playlist 10 of media content items 22 audio signals 1 are extracted as described above, according to the predefined order, each audio signal 1 having associated therewith at least one feature vector 2. In this embodiment, determining the frequency response profile 4 for any one of the plurality of audio signals 1 is based not only on its respective associated feature vector 2, but also on at least one feature vector 2 associated with a previous one of the plurality of audio signals 1 in the playlist 10, in accordance with the predefined order. Therefore, each media content item 22 can have an effect on the determined frequency response profile 4 of the subsequent media content item 22 in the playlist 10, thus ensuring a continuous, smooth listening experience and avoiding any sudden changes in equalization throughout the playlist 10.

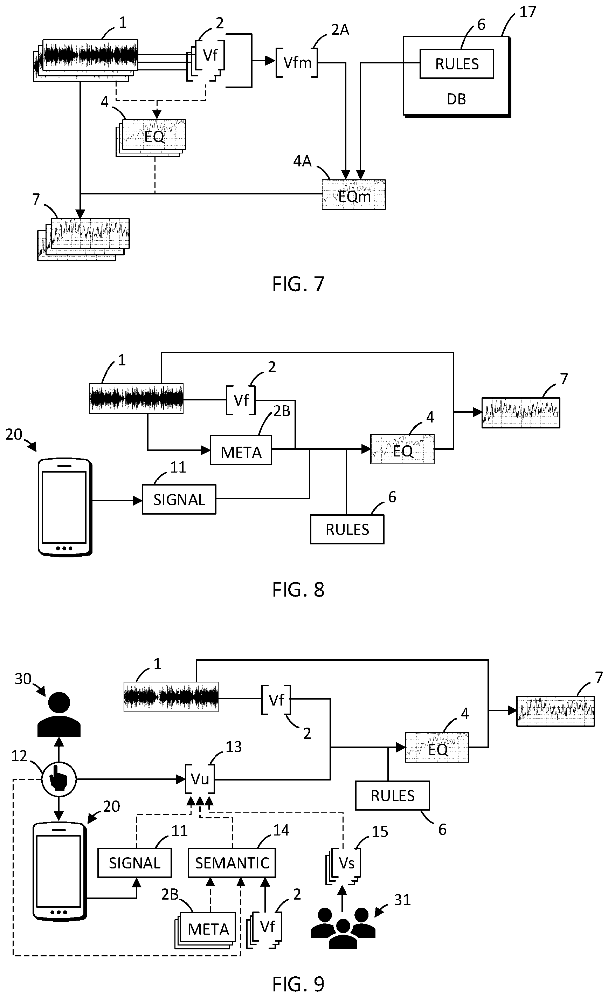

In a possible embodiment, as shown in Fig. 7, a set of audio signals 1 are received (e.g. as part of a playlist, an album, or a discography) by the audio signal equalizer 24, each audio signal 1 having an associated feature vector 2. A master feature vector 2A is also received with the set of audio signals 1, the master feature vector 2A comprising a plurality of master feature values 3A, each of the plurality of master feature values 3A representing a semantic characteristic of the set of audio signals 1. In possible embodiments, this master feature vector 2A can be determined taking into account some or all of the associated feature vectors 2 of the set of audio signals 1, for example by choosing a representative feature vector 2 corresponding to a certain representative track of an album as master feature vector 2A for all the tracks of the album, or by calculating the master feature vector 2A based on all feature vectors 2 in the set using predefined equations, such as an average or weighted average calculation, or calculating Euclidean distances between these feature vectors 2.

In a next step, a master frequency response profile 4A is determined for the set of audio signals 1 based on the master feature vector 2A, using a predefined set of rules 6 from the database 17 between the master feature values 3A and certain frequency ranges of the master frequency response profile 4A. The master frequency response profile 4A can then be applied instead of the frequency response profile 4 to each of the audio signals 1 within the set of audio signals 1 to produce a set of equalized audio signals 7. In another possible embodiment, the master frequency response profile 4A is applied in combination with the frequency response profile 4 to each of the audio signals 1, e.g. as a post-processing step. Each or any one of the equalized audio signals 7 can finally be played through the audio interface 26 as described above.

In a possible embodiment, as shown in Fig. 8, a feature vector 2 and at least one additional, metadata-based feature vector 2B is also received with the received audio signal 1. The metadata-based feature vector 2B comprises a plurality of metadata-based feature values, each of the plurality of metadata-based feature values representing a semantic characteristic of a metadata record associated with the audio signal 1. The metadata record can be any known type of metadata record, such as genre, title, artist name, band name, album name, release date, track ID (such as ISRC code, Spotify ID), etc.

In a next step, a frequency response profile 4 is determined for the audio signal 1 using a predefined set of rules 6 between the metadata-based feature values, the feature values 3, and certain frequency response profiles 4, possibly in combination with other rules 6 and inputs defined before.

In an embodiment, as also illustrated in Fig. 8, the device 20 can further comprise one or more auxiliary sensors 28 configured to generate a sensor signal 11. The sensor signal 11 from the auxiliary sensors 28 may comprise environmental information regarding at least one of a noise level, temperature, location, acceleration, or lighting; hardware information regarding the type of the device 20 or any attached accessory (such as a connected smart speaker or headset); or software information regarding operation system running on the device 20. The auxiliary sensor 28 may also be a biometric sensor forwarding biometric data of a user 30 of the device 20. In such embodiments, determining the frequency response profile 4 is further based on the received sensor signal(s) 11, using a predefined set of rules 6 between characteristics of sensor signals 11 and certain frequency ranges of the frequency response profile 4, possibly in combination with other rules 6 and inputs defined before. For example, equalization of a music track may be changed in response to whether earplugs are attached to the device 20, or whether the device 20 is attached to a docking system, or whether sound is played back using a wireless dongle (such as a Chromecast device).

In a possible embodiment, as shown in Fig. 9, at least one user interaction 12 is detected between the device 20 and a user 30 of the device 20. The user interaction 12 may comprise playing, skipping, liking, disliking, repeating, rewinding, sharing (posting, tweeting) an audio signal 1, or adding an audio signal 1 to a playlist 10, as well as adjusting manual settings using the user interface 29. A user profile vector 13 is generated and associated with the user 30 based on the detected user interactions 12. The user profile vector 13 may also originate from a user profile that is predefined on the device 20 as one of a plurality of preset user profiles ('listening types') to be adjusted and personalized by the user interactions 12.

The user profile vector 13 can then serve as a basis for determining the frequency response profile 4, using a predefined set of rules 6 between values of the user profile vector 13 and certain frequency ranges of the frequency response profile 4, possibly in combination with other rules 6 and inputs defined before.

In further possible embodiments, determining the user profile vector 13 may further be based on aggregated semantic data 14 correlating musical, emotional, and acoustic preferences of the user 30, the aggregated semantic data 14 being determined from at least one of the feature vectors 2 and the metadata-based feature vectors 2B associated with audio signals 1, based detected user interactions 12 as described above.

In further possible embodiments, determining the user profile vector 13 may further be based on social profile vectors 15 defined as user profile vectors 13 of other users 31 that are associated with the user 30 based on social relationships.

In further possible embodiments, determining the user profile vector 13 may further be based on aggregated sensor signals 11 from an auxiliary sensor 28 of the device 20 configured to measure at least one of noise level, temperature, location, acceleration, lighting, type of the device 20, operation system running on the device 20, or biometric data of a user 30 of the device 20, as described before.

In a possible embodiment, as shown in Fig. 10, the device 20 is further configured to change between a plurality of states 16, each state 16 representing at least one predefined frequency response profile 4B. In this embodiment, the device 20 further comprises at least one of a visual interface 27 configured to provide visual feedback (for example lighting up a set of colored LED lights) when the device 20 changes to one of the plurality of states 16; and an audio interface 26 configured to provide audio feedback (for example a predefined jingle) when the device 20 changes to one of the plurality of states 16.

Once the frequency response profile 4 is determined as described above, the state 16 of the device 20 changes according to the determined frequency response profile 4, which in turn triggers a visual feedback or audio feedback according to the configuration of the device 20. For example, an LED can be colored by the mood (and other data types) of the audio signal 1, thereby making the device (e.g. a smart speaker or a headset) glow to the sound and feel of the music the user 30 is experiencing. Any part of the surface of the device (smart speaker or headset) can be used for this purpose, including a cord and a beam.

Fig. 11 shows a schematic view of an illustrative computer-based system in accordance with the present disclosure, wherein the system comprises a device 20 and a database 17 in data communication with each other either directly or via a computer network. In some embodiments, the system may comprise multiple devices 20 and multiple databases 17. To prevent overcomplicating the drawing, only one device 10 and one database 17 are illustrated.

The device 20 may, according to different embodiments, be a portable media player, a cellular telephone, pocket-sized personal computer, a personal digital assistant (PDA), a smartphone, a desktop computer, a laptop computer, or any other computer-based device capable of data communication via wires or wirelessly. In some embodiments, the device 20 is a smart speaker or virtual voice assistant. In some embodiments, the device 20 is user-wearable, such as a headset.

The database 17 may refer to any suitable types of databases that are configured to store and provide data to a client device or application. The database 17 may be part of, or in data communication with, the device 20 and/or a server connected to the device 20.

The device 20 may include a storage medium 21, an audio signal processor 23, a processor 25, an audio signal equalizer 24, a memory, a communications interface, a user interface 29 comprising an input device 29A and an output device 29B, an audio interface 26, a visual interface 27, and any number of auxiliary sensors 28, and an internal bus. The device 20 may include other components not shown in Fig. 11, such as a power supply for providing power to the components of the computer-based system. Also, while only one of each component is illustrated, the computer-based system can include more than one of some or all of the components.

The storage medium 21 is configured to store information, such as the plurality of media content items 22 and their associated feature vectors 2, as well as instructions to be executed by the processor 25. The storage medium 21 can be any suitable type of storage medium offering permanent or semi-permanent memory. For example, the storage medium 16 can include one or more storage mediums, including for example, a hard drive, Flash, or other EPROM or EEPROM.

The processor 25 controls the operation and various functions of the device 20 and/or the whole system. As described in detail above, the processor 25 can be configured to control the components of the computer-based system to execute a method of optimizing audio playback, in accordance with the present disclosure, by determining at least one frequency response profile 4 for the audio signal 1 based on different inputs. The processor 25 can include any components, circuitry, or logic operative to drive the functionality of the computer-based system. For example, the processor 25 can include one or more processors acting under the control of an application. In some embodiments, this application can be stored in a memory. The memory can include cache memory, flash memory, read only memory, random access memory, or any other suitable type of memory. In some embodiments, the memory can be dedicated specifically to storing firmware for a processor 25. For example, the memory can store firmware for device applications.

The audio signal processor 23 is configured to extract an audio signal 1 from a media content item 22.

The audio signal equalizer 24 is configured to produce an equalized audio signal 7 based on an audio signal 1 and at least one frequency response profile 4.

An internal bus may provide a data transfer path for transferring data to, from, or between some or all of the other components of the device 20 and/or the computer-based system.

A communications interface may enable the device 20 to communicate with other components, such as the database 17, either directly or via a computer network. For example, communications interface can include Wi-Fi enabling circuitry that permits wireless communication according to one of the 802.11 standards or a private network. Other wired or wireless protocol standards, such as Bluetooth, can be used in addition or instead.

The input device 29A and output device 29B provides a user interface 29 for a user 30 for interaction and feedback, together with the audio interface 26, visual interface 27, and auxiliary sensors 28.

The input device 29A may enable a user to provide input and feedback to the device 20. The input device 29A can take any of a variety of forms, such as one or more of a button, keypad, keyboard, mouse, dial, click wheel, touch screen, or accelerometer.

The output device 29B can present visual media and can be configured to show a GUI to the user 30. The output device 29B can be a display screen, for example a liquid crystal display, a touchscreen display, or any other type of display.

The audio interface 26 can provide an interface by which the device 20 can provide music and other audio elements such as alerts or audio feedback about a change of state 16 to a user 30. The audio interface 26 can include any type of speaker, such as computer speakers or headphones.

The visual interface 27 can provide an interface by which the device 20 can provide visual feedback about a change of state 16 to a user 30, for example using a set of colored LED lights, similarly as implemented in e.g. a Philips Hue device.

The auxiliary sensor 28 may be any sensor configured to measure and/or detect noise level, temperature, location, acceleration, lighting, the type of the device 20, the operation system running on the device 20, a gesture or biometric data of a user 30 of the device 20, or radar or LiDAR data.

The various aspects and implementations have been described in conjunction with various embodiments herein. However, other variations to the disclosed embodiments can be understood and effected by those skilled in the art in practicing the claimed subject-matter, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems.

The reference signs used in the claims shall not be construed as limiting the scope.

## Claims

1. A computer-implemented method for optimizing audio playback on a device (20), the device (20) comprising an audio interface (26) and at least one auxiliary sensor (28) configured to generate a sensor signal (11) comprising information regarding at least one of noise level, temperature, location, acceleration, lighting, type of the device (20), operation system running on the device (20), or biometric data of a user (30) of the device (20), the method comprising:
receiving an audio signal (1) and at least one feature vector (2) associated with said audio signal (1), said feature vector (2) comprising a plurality of feature values (3), each of said plurality of feature values (3) representing a semantic characteristic of the audio signal (1);
receiving at least one sensor signal (11) from said at least one auxiliary sensor (28);
determining at least one frequency response profile (4) for said audio signal (1) based on said at least one feature vector (2) and said at least one sensor signal (11) using a set of rules (6) between said feature values (3), said sensor signals (11), and certain frequency ranges of said frequency response profile (4) respectively;
applying said at least one frequency response profile (4) to the audio signal (1) to produce an equalized audio signal (7); and
playing the equalized audio signal (7) through the audio interface (26).

2. A method according to claim 1, wherein the device (20) comprises a storage medium (21), and wherein determining said at least one frequency response profile (4) comprises:
providing at least one predefined frequency response profile (4B) stored in the storage medium (21); and
selecting at least one of the predefined frequency response profiles (4B) based on said at least one feature vector (2), using a predefined set of rules (6) between said feature values (3) and certain predefined frequency response profiles (4B).

3. A method according to any one of claims 1 or 2,
wherein said frequency response profile (4) is divided into a plurality of frequency response bands (5), each frequency response band (5) associated with a range of frequencies between two predefined limits *L1, L2* corresponding to the audible frequency spectrum; and
wherein determining said at least one frequency response profile (4) comprises:
assigning a variable (8) to each frequency response band, wherein a value of each variable (8) defines a frequency response (output-input ratio of amplification) of the assigned frequency response band (5);
adjusting said variables (8) based on said at least one feature vector (2), wherein each variable (8) value is associated with one or more feature values (3) of said feature vector (2); and
determining said frequency response profile (4) based on values of assigned variables (8) for each respective frequency response band (5).

4. A method according to any one of claims 1 to 3, wherein the audio signal (1) comprises a plurality of audio segments (9), at least one of said audio segments (9) having associated therewith a feature vector (2), said feature vector (2) comprising feature values (3) representing a semantic characteristic of the respective audio segment (9); and wherein the method comprises
determining a frequency response profile (4) for each audio segment (9) based on at least one of
- a feature vector (2) associated with the respective audio segment (9),
- a feature vector (2) associated with a closest audio segment (9) to the respective audio segment (9) with an associated feature vector (2), or
- a feature vector (2) determined based on interpolation between feature vectors (2) associated with closest audio segments (9) before and after the respective audio segment (9) with associated feature vectors (2);
applying said determined frequency response profile (4) to each representative audio segment (9) of the audio signal (1) to produce a continuously equalized audio signal (7C); and
playing the continuously equalized audio signal (7C) through the audio interface (26).

5. A method according to claim 4, wherein determining said frequency response profile (4) for each audio segment (9) is further based on a composition profile (4C), said composition profile (4C) being determined based on a chronological sequence of all feature vectors (2) associated with said audio signal (1).

6. A method according to any one of claims 1 to 5, wherein the method comprises
receiving a playlist (10) comprising a plurality of audio signals (1) in a predefined order, each audio signal (1) having associated therewith at least one feature vector (2); and wherein
determining said at least one frequency response profile (4) for one of said plurality of audio signals (1) is based on at least one feature vector (2) associated with a previous one of said plurality of audio signals (1) in said playlist (10), in accordance with said predefined order.

7. A method according to any one of claims 1 to 6, wherein the method comprises
receiving a set of audio signals (1), and a master feature vector (2A) associated with the set of audio signals (1), said master feature vector (2A) comprising a plurality of master feature values (3A), each of said plurality of master feature values (3A) representing a semantic characteristic of the set of audio signals (1);
determining a master frequency response profile (4A) for said set of audio signals (1) based on said master feature vector (2A) using a predefined set of rules (6) between said master feature values (3A) and certain frequency ranges of said master frequency response profile (4A);
applying said master frequency response profile (4A) to each of the audio signals (1) within said set of audio signals (1) instead or in combination with said determined at least one frequency response profile (4) to produce a set of equalized audio signals (7); and
playing at least one equalized audio signal (7) from said set of equalized audio signals (7) through the audio interface (26).

8. A method according to claim 7, wherein said master feature vector (2A) is determined based on a plurality or all associated feature vectors (2) of said set of audio signals (1).

9. A method according to any one of claims 1 to 8, further comprising:
receiving at least one additional, metadata-based feature vector (2B) associated with said received audio signal (1), said metadata-based feature vector (2B) comprising a plurality of metadata-based feature values, each of said plurality of metadata-based feature values representing a semantic characteristic of a metadata record associated with said audio signal (1); wherein
determining said at least one frequency response profile (4) for said audio signal (1) is further based on said metadata-based feature vector (2B), using a predefined set of rules (6) between said metadata-based feature values, said feature values (3), and certain predefined frequency response profiles (4B).

10. A method according to any one of claims 1 to 9, wherein said semantic characteristic is one of
a perceived musical characteristic corresponding to a musical style, musical genre, musical sub-genre, rhythm, tempo, vocals, or instrumentation; or
a perceived emotional characteristic corresponding to a mood.

11. A method according to any one of claims 1 to 10, wherein the method further comprises:
detecting at least one user interaction (12) between the device (20) and a user (30) of the device (20), said user interaction (12) comprising at least one of playing, skipping, liking, disliking, repeating, rewinding an audio signal (1), or adding an audio signal (1) to a playlist (10);
determining a user profile vector (13) associated with said user (30) based on at least said detected user interactions (12); wherein
determining said frequency response profile (4) is further based on a user profile vector (13) associated with said user (30) using a predefined set of rules (6) between values of said user profile vector (13) and certain frequency ranges of said frequency response profile (4).

12. A method according to claim 11, wherein determining said user profile vector (13) is further based on at least one of:
- aggregated semantic data (14) correlating musical, emotional, and acoustic preferences of said user (30), said aggregated semantic data (14) being determined from at least one of said feature vectors (2) and said metadata-based feature vectors (2B) associated with audio signals (1), based on said detected user interactions (12),
- social profile vectors (15) defined as user profile vectors (13) of other users (31) that are associated with said user (30) based on social relationships; and
- aggregated sensor signals (11) from said auxiliary sensor (28).

13. A method according to any one of claims 1 to 12, wherein the device (20) is further configured to change between a plurality of states (16), each state (16) representing at least one predefined frequency response profile (4B), wherein the device (20) comprises at least one of
- a visual interface (27) configured to provide visual feedback when the device (20) changes to one of said plurality of states (16); and
- an audio interface (26) configured to provide audio feedback when the device (20) changes to one of said plurality of states (16);
and wherein the method further comprises:
changing the state (16) of the device (20) according to the determined frequency response profile (4); and
providing at least one of a visual feedback or audio feedback according to the configuration of the device (20).

14. A computer-based system for optimizing audio playback, the system comprising:
a storage medium (21) comprising a plurality of media content items (22), at least one feature vector (2) associated with each of said media content items (22), each feature vector (2) comprising a plurality of feature values (3), each of said plurality of feature values (3) representing a semantic characteristic of the respective media content item (22);
at least one auxiliary sensor (28) arranged in a device (20) and configured to generate a sensor signal (11) comprising information regarding at least one of noise level, temperature, location, acceleration, lighting, type of said device (20), operation system running on said device (20), or biometric data of a user (30) of said device (20);
a database (17) comprising a set of rules (6) defining logical relationships between at least said feature values (3), said sensor signal (11), and certain frequency ranges of a frequency response profile (4) respectively;
an audio signal processor (23) configured to extract an audio signal (1) from a media content item (22);
a processor (25) configured to determine at least one frequency response profile (4) for said audio signal (1) based on said at least one associated feature vector (2) and said sensor signal (11), using said set of rules (6);
an audio signal equalizer (24) configured to produce an equalized audio signal (7) based on an audio signal (1) and at least one frequency response profile (4), according to the method steps of any one of claims 1 to 13; and
an audio interface (26) configured to play the equalized audio signal (7).

15. A non-transitory computer readable medium storing instructions which, when executed by a processor (25) of a computer-based system according to claim 14, cause the processor (25) to perform a method according to any one of claims 1 to 13.

## Patentansprüche

1. Computerimplementiertes Verfahren zur Optimierung einer Audiowiedergabe auf einer Vorrichtung (20), wobei die Vorrichtung (20) eine Audioschnittstelle (26) und mindestens einen Hilfssensor (28) umfasst, der dazu konfiguriert ist, ein Sensorsignal (11) zu erzeugen, das Informationen in Bezug auf mindestens einen bzw. eine bzw. eines von einem Rauschpegel, einer Temperatur, einem Standort, einer Beschleunigung, einer Beleuchtung, einem Typ der Vorrichtung (20), einem Betriebssystem, das auf der Vorrichtung (20) ausgeführt wird, oder biometrischen Daten eines Benutzers (30) der Vorrichtung (20) umfasst, wobei das Verfahren umfasst:
Empfangen eines Audiosignals (1) und mindestens eines Merkmalsvektors (2), der mit dem Audiosignal (1) assoziiert ist, wobei der Merkmalsvektor (2) eine Vielzahl von Merkmalswerten (3) umfasst, wobei jeder der Vielzahl von Merkmalswerten (3) ein semantisches Charakteristikum des Audiosignals (1) darstellt;
Empfangen mindestens eines Sensorsignals (11) von dem mindestens einen Hilfssensor (28);
Bestimmen mindestens eines Frequenzgangprofils (4) für das Audiosignal (1) auf der Basis des mindestens einen Merkmalsvektors (2) und des mindestens einen Sensorsignals (11) unter Verwendung eines Satzes von Regeln (6) zwischen den Merkmalswerten (3), den Sensorsignalen (11) bzw. bestimmten Frequenzbereichen des Frequenzgangprofils (4);
Anwenden des mindestens einen Frequenzgangprofils (4) auf das Audiosignal (1), um ein entzerrtes Audiosignal (7) zu produzieren; und
Abspielen des entzerrten Audiosignals (7) durch die Audioschnittstelle (26).

2. Verfahren nach Anspruch 1, wobei die Vorrichtung (20) ein Speichermedium (21) umfasst, und wobei das Bestimmen des mindestens einen Frequenzgangprofils (4) umfasst:
Bereitstellen mindestens eines vordefinierten Frequenzgangprofils (4B), das in dem Speichermedium (21) gespeichert ist; und
Auswählen mindestens eines der vordefinierten Frequenzgangprofile (4B) auf der Basis des mindestens einen Merkmalsvektors (2) unter Verwendung eines vordefinierten Satzes von Regeln (6) zwischen den Merkmalswerten (3) und bestimmten vordefinierten Frequenzgangprofilen (4B).

3. Verfahren nach einem der Ansprüche 1 oder 2,
wobei das Frequenzgangprofil (4) in eine Vielzahl von Frequenzgangbändern (5) unterteilt ist, wobei jedes Frequenzgangband (5) mit einem Bereich von Frequenzen zwischen zwei vordefinierten Grenzen *L1, L2,* die dem hörbaren Frequenzspektrum entsprechen, assoziiert ist; und
wobei das Bestimmen des mindestens einen Frequenzgangprofils (4) umfasst:
Zuteilen einer Variable (8) zu jedem Frequenzgangband, wobei ein Wert jeder Variable (8) einen Frequenzgang (Ausgabe-Eingabe-Verhältnis einer Verstärkung) des zugeteilten Frequenzgangbands (5) definiert;
Justieren der Variablen (8) auf der Basis des mindestens einen Merkmalsvektors (2), wobei jeder Wert einer Variable (8) mit einem oder mehreren Merkmalswerten (3) des Merkmalsvektors (2) assoziiert ist; und
Bestimmen des Frequenzgangprofils (4) auf der Basis von Werten von zugeteilten Variablen (8) für jedes jeweilige Frequenzgangband (5).

4. Verfahren nach einem der Ansprüche 1 bis 3, wobei
das Audiosignal (1) eine Vielzahl von Audiosegmenten (9) umfasst, wobei mindestens eines der Audiosegmente (9) einen Merkmalsvektoren (2) damit assoziiert aufweist, wobei der Merkmalsvektor (2) Merkmalswerte (3) umfasst, die ein semantisches Charakteristikum des jeweiligen Audiosegments (9) darstellen; und wobei das Verfahren umfasst:
Bestimmen eines Frequenzgangprofils (4) für jedes Audiosegment (9) auf der Basis mindestens eines von
- einem Merkmalsvektor (2), der mit dem jeweiligen Audiosegment (9) assoziiert ist,
- einem Merkmalsvektor (2), der mit einem nächsten Audiosegment (9) zu dem jeweiligen Audiosegment (9) mit einem assoziierten Merkmalsvektor (2) assoziiert ist, oder
- einem Merkmalsvektor (2), der auf der Basis einer Interpolation zwischen Merkmalsvektoren (2), die mit nächsten Audiosegmenten (9) vor und hinter dem jeweiligen Audiosegment (9) mit assoziierten Merkmalsvektoren (2) assoziiert sind, bestimmt wird;
Anwenden des bestimmten Frequenzgangprofils (4) auf jedes darstellende Audiosegment (9) des Audiosignals (1), um ein kontinuierlich entzerrtes Audiosignal (7C) zu produzieren; und
Abspielen des kontinuierlich entzerrten Audiosignals (7C) durch die Audioschnittstelle (26).

5. Verfahren nach Anspruch 4, wobei das Bestimmen des Frequenzgangprofils (4) für jedes Audiosegment (9) ferner auf einem Zusammensetzungsprofil (4C) basiert, wobei das Zusammensetzungsprofil (4C) auf der Basis einer chronologischen Abfolge aller Merkmalsvektoren (2), die mit dem Audiosignal (1) assoziiert sind, bestimmt wird.

6. Verfahren nach einem der Ansprüche 1 bis 5, wobei das Verfahren umfasst:
Empfangen einer Wiedergabeliste (10), die eine Vielzahl von Audiosignalen (1) in einer vordefinierten Reihenfolge umfasst, wobei jedes Audiosignal (1) mindestens einen Merkmalsvektor (2) damit assoziiert aufweist; und wobei
das Bestimmen des mindestens einen Frequenzgangprofils (4) für eines der Vielzahl von Audiosignalen (1) auf mindestens einem Merkmalsvektor (2), der mit einem vorherigen einen der Vielzahl von Audiosignalen (1) in der Wiedergabeliste (10) assoziiert ist, gemäß der vordefinierten Reihenfolge basiert.

7. Verfahren nach einem der Ansprüche 1 bis 6, wobei das Verfahren umfasst:
Empfangen eines Satzes von Audiosignalen (1) und eines Master-Merkmalsvektors (2A), der mit dem Satz von Audiosignalen (1) assoziiert ist, wobei der Master-Merkmalsvektor (2A) eine Vielzahl von Master-Merkmalswerten (3A) umfasst, wobei jeder der Vielzahl von Master-Merkmalswerten (3A) ein semantisches Charakteristikum des Satzes von Audiosignalen (1) darstellt;
Bestimmen eines Master-Frequenzgangprofils (4A) für den Satz von Audiosignalen (1) auf der Basis des Master-Merkmalsvektors (2A) unter Verwendung eines vordefinierten Satzes von Regeln (6) zwischen den Master-Merkmalswerten (3A) und bestimmten Frequenzbereichen des Master-Frequenzgangprofils (4A);
Anwenden des Master-Frequenzgangprofils (4A) auf jedes der Audiosignale (1) innerhalb des Satzes von Audiosignalen (1) anstelle des oder in Kombination mit dem bestimmten mindestens einen Frequenzgangprofil (4), um einen Satz von entzerrten Audiosignalen (7) zu produzieren; und
Abspielen mindestens eines entzerrten Audiosignals (7) von dem Satz von entzerrten Audiosignalen (7) durch die Audioschnittstelle (26).

8. Verfahren nach Anspruch 7, wobei der Master-Merkmalsvektor (2A) auf der Basis einer Vielzahl von oder aller assoziierten Merkmalsvektoren (2) des Satzes von Audiosignalen (1) bestimmt wird.

9. Verfahren nach einem der Ansprüche 1 bis 8, ferner umfassend:
Empfangen mindestens eines zusätzlichen, auf Metadaten basierenden Merkmalsvektors (2B), der mit dem empfangenen Audiosignal (1) assoziiert ist, wobei der auf Metadaten basierende Merkmalsvektor (2B) eine Vielzahl von auf Metadaten basierenden Merkmalswerten umfasst, wobei jeder der Vielzahl von auf Metadaten basierenden Merkmalswerte ein semantisches Charakteristikum eines Metadatensatzes, der mit dem Audiosignal (1) assoziiert ist, darstellt; wobei
das Bestimmen des mindestens einen Frequenzgangprofils (4) für das Audiosignal (1) ferner auf dem auf Metadaten basierenden Merkmalsvektor (2B) unter Verwendung eines vordefinierten Satzes von Regeln (6) zwischen den auf Metadaten basierenden Merkmalsvektoren, den Merkmalswerten (3) und bestimmten vordefinierten Frequenzgangprofilen (4B) basiert.

10. Verfahren nach einem der Ansprüche 1 bis 9, wobei das semantische Charakteristikum eines von
einem wahrgenommenen musikalischem Charakteristikum, das einem Musikstil, einem Musikgenre, einem Musiksubgenre, einem Rhythmus, einem Tempo, einem Gesang oder einer Orchestrierung entspricht; oder
einem wahrgenommenen emotionalen Charakteristikum, das einer Stimmungslage entspricht, ist.

11. Verfahren nach einem der Ansprüche 1 bis 10, wobei das Verfahren ferner umfasst:
Erfassen mindestens einer Benutzerinteraktion (12) zwischen der Vorrichtung (20) und einem Benutzer (30) der Vorrichtung (20), wobei die Benutzerinteraktion (12) mindestens eines von einem Abspielen, Überspringen, Liken, Disliken, Wiederholen, Zurückspulen eines Audiosignals (1) oder Hinzufügen eines Audiosignals (1) zu einer Wiedergabeliste (10) umfasst;
Bestimmen eines Benutzerprofilvektors (13), der mit dem Benutzer (30) assoziiert ist, auf der Basis mindestens der erfassten Benutzerinteraktionen (12); wobei
das Bestimmen des Frequenzgangprofils (4) ferner auf einem Benutzerprofilvektor (13), der mit dem Benutzer (30) assoziiert ist, unter Verwendung eines vordefinierten Satzes von Regeln (6) zwischen Werten des Benutzerprofilvektors (13) und bestimmten Frequenzbereichen des Frequenzgangprofils (4) basiert.

12. Verfahren nach Anspruch 11, wobei das Bestimmen des Benutzerprofilvektors (13) ferner auf mindestens einem von:
- aggregierten semantischen Daten (14), die Musik-, emotionale und akustische Präferenzen des Benutzers (30) korrelieren, wobei die aggregierten semantischen Daten (14) aus mindestens einem der Merkmalsvektoren (2) und den auf Metadaten basierenden Merkmalsvektoren (2B), die mit Audiosignalen (1) assoziiert sind, auf der Basis der erfassten Benutzerinteraktionen (12) bestimmt werden,
- Sozialprofilvektoren (15), die als Benutzerprofilvektoren (13) anderer Benutzer (31) definiert sind, die mit dem Benutzer (30) auf der Basis sozialer Beziehungen assoziiert sind; und
- aggregierten Sensorsignalen (11) von dem Hilfssensor (28) basiert.

13. Verfahren nach einem der Ansprüche 1 bis 12, wobei
die Vorrichtung (20) ferner dazu konfiguriert ist, zwischen einer Vielzahl von Zuständen (16) zu wechseln, wobei jeder Zustand (16) mindestens ein vordefiniertes Frequenzgangprofil (4B) darstellt, wobei die Vorrichtung (20) mindestens eine von
- einer visuellen Schnittstelle (27), die dazu konfiguriert ist, eine visuelle Rückmeldung bereitzustellen, wenn die Vorrichtung (20) zu einem der Vielzahl von Zuständen (16) wechselt; und
- einer Audioschnittstelle (26), die dazu konfiguriert ist, eine Audiorückmeldung bereitzustellen, wenn die Vorrichtung (20) zu einem der Vielzahl von Zuständen (16) wechselt, umfasst;
und wobei das Verfahren ferner umfasst:
Wechseln des Zustands (16) der Vorrichtung (20) gemäß dem bestimmten Frequenzgangprofil (4); und
Bereitstellen mindestens einer von einer visuellen Rückmeldung oder einer Audiorückmeldung gemäß der Konfiguration der Vorrichtung (20).

14. Computerbasiertes System zur Optimierung einer Audiowiedergabe, wobei das System umfasst:
ein Speichermedium (21), umfassend eine Vielzahl von Medieninhaltselementen (22), wobei mindestens ein Merkmalsvektor (2) mit jedem der Medieninhaltselemente (22) assoziiert ist, wobei jeder Merkmalsvektor (2) eine Vielzahl von Merkmalswerten (3) umfasst, wobei jeder der Vielzahl von Merkmalswerten (3) ein semantisches Charakteristikum des jeweiligen Medieninhaltselements (22) darstellt;
mindestens einen Hilfssensor (28), der in einer Vorrichtung (20) eingerichtet ist und dazu konfiguriert ist, ein Sensorsignal (11) zu erzeugen, das Informationen in Bezug auf mindestens einen bzw. eine bzw. eines von einem Rauschpegel, einer Temperatur, einem Standort, einer Beschleunigung, einer Beleuchtung, einem Typ der Vorrichtung (20), einem Betriebssystem, das auf der Vorrichtung (20) ausgeführt wird, oder biometrischen Daten eines Benutzers (30) der Vorrichtung (20) umfasst;
eine Datenbank (17), die einen Satz von Regeln (6) umfasst, die logische Beziehungen zwischen mindestens den Merkmalswerten (3), dem Sensorsignal (11) bzw. bestimmten Frequenzbereichen eines Frequenzgangprofils (4) definieren;
einen Audiosignalprozessor (23), der dazu konfiguriert ist, ein Audiosignal (1) aus einem Medieninhaltselement (22) zu extrahieren;
einen Prozessor (25), der dazu konfiguriert ist, mindestens ein Frequenzgangprofil (4) für das Audiosignal (1) auf der Basis des mindestens einen assoziierten Merkmalsvektors (2) und des Sensorsignals (11) unter Verwendung des Satzes von Regeln (6) zu bestimmen;
einen Audiosignalentzerrer (24), der dazu konfiguriert ist, ein entzerrtes Audiosignal (7) auf der Basis eines Audiosignals (1) und mindestens eines Frequenzgangprofils (4) gemäß den Verfahrensschritten nach einem der Ansprüche 1 bis 13 zu produzieren; und
eine Audioschnittstelle (26), die dazu konfiguriert ist, das entzerrte Audiosignal (7) abzuspielen.

15. Nichtflüchtiges computerlesbares Medium, das Anweisungen speichert, die bei Ausführung durch einen Prozessor (25) eines computerbasierten Systems nach Anspruch 14 bewirken, dass der Prozessor (25) ein Verfahren nach einem der Ansprüche 1 bis 13 durchführt.

## Revendications

1. Procédé implémenté sur ordinateur pour optimiser une lecture audio sur un dispositif (20), le dispositif (20) comprenant une interface audio (26) et au moins un capteur auxiliaire (28) configuré pour générer un signal (11) de capteur comprenant des informations concernant au moins un(e) parmi niveau de bruit, température, emplacement, accélération, éclairage, type du dispositif (20), système d'exploitation fonctionnant sur le dispositif (20), ou données biométriques d'un utilisateur (30) du dispositif (20), le procédé comprenant les étapes consistant à :
recevoir un signal audio (1) et au moins un vecteur (2) de caractéristiques associé audit signal audio (1), ledit vecteur (2) de caractéristiques comprenant une pluralité de valeurs de caractéristiques (3), chacune parmi ladite pluralité de valeurs de caractéristiques (3) représentant une caractéristique sémantique du signal audio (1) ;
recevoir au moins un signal (11) de capteur depuis ledit au moins un capteur auxiliaire (28) ;
déterminer au moins un profil de réponse en fréquence (4) pour ledit signal audio (1) sur la base dudit au moins un vecteur (2) de caractéristiques et dudit au moins un signal (11) de capteur en utilisant un ensemble de règles (6) entre lesdites valeurs de caractéristiques (3), lesdits signaux (11) de capteur, et certaines plages de fréquences dudit profil de réponse en fréquence (4) respectivement ;
appliquer ledit au moins un profil de réponse en fréquence (4) au signal audio (1) pour produire un signal audio égalisé (7) ; et
lire le signal audio égalisé (7) via l'interface audio (26).

2. Procédé selon la revendication 1, dans lequel le dispositif (20) comprend un support de stockage (21), et dans lequel déterminer ledit au moins un profil de réponse en fréquence (4) comprend :
fournir au moins un profil de réponse en fréquence prédéfini (4B) stocké dans le support de stockage (21) ; et
sélectionner au moins un des profils de réponse en fréquence prédéfinis (4B) sur la base dudit au moins un vecteur (2) de caractéristiques, en utilisant un ensemble prédéfini de règles (6) entre lesdites valeurs de caractéristiques (3) et certains profils de réponse en fréquence prédéfinis (4B).

3. Procédé selon l'une quelconque des revendications 1 et 2,
dans lequel ledit profil de réponse en fréquence (4) est divisé en une pluralité de bandes de réponse en fréquence (5), chaque bande de réponse en fréquence (5) étant associée à une plage de fréquences comprise entre deux limites *L1, L2* prédéfinies, correspondant au spectre de fréquences audibles ; et
dans lequel déterminer ledit au moins un profil de réponse en fréquence (4) comprend :
attribuer une variable (8) à chaque bande de réponse en fréquence, une valeur de chaque variable (8) définissant une réponse en fréquence (rapport sortie-entrée d'amplification) de la bande de réponse en fréquence (5) ayant reçu l'attribution ;
ajuster lesdites variables (8) sur la base dudit au moins un vecteur (2) de caractéristiques, chaque valeur de variable (8) étant associée à une ou plusieurs valeurs de caractéristiques (3) dudit vecteur (2) de caractéristiques ; et
déterminer ledit profil de réponse en fréquence (4) sur la base des valeurs des variables attribuées (8) pour chaque bande de réponse en fréquence (5) respective.

4. Procédé selon l'une quelconque des revendications 1 à 3, dans lequel
le signal audio (1) comprend une pluralité de segments audio (9), au moins un desdits segments audio (9) comportant un vecteur (2) de caractéristiques qui y est associé, ledit vecteur (2) de caractéristiques comprenant des valeurs de caractéristiques (3) représentant une caractéristique sémantique du segment audio (9) respectif ; et dans lequel le procédé comprend
déterminer un profil de réponse en fréquence (4) pour chaque segment audio (9) sur la base d'au moins un parmi
- un vecteur (2) de caractéristiques associé au segment audio (9) respectif,
- un vecteur (2) de caractéristiques associé à un segment audio (9) le plus proche du segment audio (9) respectif comportant un vecteur (2) de caractéristiques associé, ou
- un vecteur (2) de caractéristiques déterminé sur la base d'une interpolation entre les vecteurs (2) de caractéristiques associés aux segments audio (9) les plus proches avant et après le segment audio (9) respectif, comportant des vecteurs (2) de caractéristiques associés ;
appliquer ledit profil de réponse en fréquence déterminé (4) à chaque segment audio (9) représentatif du signal audio (1) pour produire un signal audio égalisé en continu (7C) ; et
lire le signal audio égalisé en continu (7C) via l'interface audio (26).

5. Procédé selon la revendication 4, dans lequel déterminer ledit profil de réponse en fréquence (4) pour chaque segment audio (9) est en outre basé sur un profil de composition (4C), ledit profil de composition (4C) étant déterminé sur la base d'une séquence chronologique de tous les vecteurs (2) de caractéristiques associés audit signal audio (1).

6. Procédé selon l'une quelconque des revendications 1 à 5, dans lequel le procédé comprend
recevoir une liste de lecture (10) comprenant une pluralité de signaux audio (1) dans un ordre prédéfini, à chaque signal audio (1) étant associé au moins un vecteur (2) de caractéristiques ; et dans lequel
déterminer ledit au moins un profil de réponse en fréquence (4) pour l'un parmi ladite pluralité de signaux audio (1) est basé sur au moins un vecteur (2) de caractéristiques associé à un signal audio précédent parmi ladite pluralité de signaux audio (1) dans ladite liste de lecture (10), conformément audit ordre prédéfini.

7. Procédé selon l'une quelconque des revendications 1 à 6, dans lequel le procédé comprend
recevoir un ensemble de signaux audio (1) et un vecteur (2A) de caractéristiques maîtresses associé à l'ensemble de signaux audio (1), ledit vecteur (2A) de caractéristiques maîtresses comprenant une pluralité de valeurs de caractéristiques maîtresses (3A), chacune parmi ladite pluralité de valeurs de caractéristiques maîtresses (3A) représentant une caractéristique sémantique de l'ensemble de signaux audio (1) ;
déterminer un profil de réponse en fréquence maître (4A) pour ledit ensemble de signaux audio (1) sur la base dudit vecteur (2A) de caractéristiques maîtresses en utilisant un ensemble prédéfini de règles (6) entre lesdites valeurs de caractéristiques maîtresses (3A) et certaines plages de fréquences dudit profil de réponse en fréquence maître (4A) ;
appliquer ledit profil de réponse en fréquence maître (4A) à chacun des signaux audio (1) au sein dudit ensemble de signaux audio (1) au lieu dudit ou en association avec ledit au moins un profil de réponse en fréquence déterminé (4) pour produire un ensemble de signaux audio égalisés (7) ; et
lire au moins un signal audio égalisé (7) dudit ensemble de signaux audio égalisés (7) via l'interface audio (26).

8. Procédé selon la revendication 7, dans lequel ledit vecteur (2A) de caractéristiques maîtresses est déterminé sur la base d'une pluralité ou de la totalité des vecteurs (2) de caractéristiques associés dudit ensemble de signaux audio (1).

9. Procédé selon l'une quelconque des revendications 1 à 8, comprenant en outre :
recevoir au moins un vecteur de caractéristiques supplémentaire (2B), basé sur des métadonnées, associé audit signal audio (1) reçu, ledit vecteur de caractéristiques (2B) basé sur des métadonnées comprenant une pluralité de valeurs de caractéristiques basées sur des métadonnées, chacune parmi ladite pluralité de valeurs de caractéristiques basées sur des métadonnées représentant une caractéristique sémantique d'un enregistrement de métadonnées associé audit signal audio (1) ; dans lequel
déterminer ledit au moins un profil de réponse en fréquence (4) pour ledit signal audio (1) est en outre basé sur ledit vecteur (2B) de caractéristiques basé sur des métadonnées, en utilisant un ensemble prédéfini de règles (6) entre lesdites valeurs de caractéristiques basées sur des métadonnées, lesdites valeurs de caractéristiques (3) et certains profils de réponse en fréquence prédéfinis (4B).

10. Procédé selon l'une quelconque des revendications 1 à 9, dans lequel ladite caractéristique sémantique est l'une parmi
une caractéristique musicale perçue correspondant à un style musical, un genre musical, un sous-genre musical, un rythme, un tempo, une partie vocale, ou une instrumentation ; ou
une caractéristique émotionnelle perçue correspondant à une ambiance.

11. Procédé selon l'une quelconque des revendications 1 à 10, le procédé comprenant en outre :
détecter au moins une interaction (12) d'utilisateur entre le dispositif (20) et un utilisateur (30) du dispositif (20), ladite interaction (12) d'utilisateur comprenant au moins une parmi lire, passer, aimer, ne pas aimer, répéter, remettre en arrière un signal audio (1) ou ajouter un signal audio (1) à une liste de lecture (10) ;
déterminer un vecteur de profil (13) d'utilisateur associé audit utilisateur (30) sur la base d'au moins lesdites interactions d'utilisateur détectées (12) ; dans lequel
déterminer ledit profil de réponse en fréquence (4) est en outre basé sur un vecteur de profil (13) d'utilisateur associé audit utilisateur (30) en utilisant un ensemble prédéfini de règles (6) entre des valeurs dudit vecteur de profil (13) d'utilisateur et certaines plages de fréquences dudit profil de réponse en fréquence (4).

12. Procédé selon la revendication 11, dans lequel déterminer ledit vecteur de profil (13) d'utilisateur est en outre basé sur au moins un parmi :
- des données sémantiques agrégées (14) corrélant des préférences musicales, émotionnelles, et acoustiques dudit utilisateur (30), lesdites données sémantiques agrégées (14) étant déterminées à partir d'au moins un desdits vecteurs (2) de caractéristiques et desdits vecteurs (2B) de caractéristiques basés sur des métadonnées associés aux signaux audio (1), sur la base desdites interactions d'utilisateur détectées (12),
- des vecteurs de profil social (15) définis comme des vecteurs de profil (13) d'utilisateur d'autres utilisateurs (31) qui sont associés audit utilisateur (30) sur la base de relations sociales ; et
- des signaux de capteur agrégés (11) provenant dudit capteur auxiliaire (28).

13. Procédé selon l'une quelconque des revendications 1 à 12, dans lequel le dispositif (20) est en outre configuré pour changer entre une pluralité d'états (16), chaque état (16) représentant au moins un profil de réponse en fréquence prédéfini (4B), le dispositif (20) comprenant au moins une parmi
une interface visuelle (27) configurée pour fournir une rétroaction visuelle lorsque le dispositif (20) passe à l'un parmi ladite pluralité d'états (16) ; et
une interface audio (26) configurée pour fournir une rétroaction audio lorsque le dispositif (20) passe à l'un parmi ladite pluralité d'états (16) ;
et dans lequel le procédé comprend en outre :
changer l'état (16) du dispositif (20) en fonction du profil de réponse en fréquence (4) déterminé ; et
fournir au moins une parmi une rétroaction visuelle ou une interaction audio en fonction de la configuration du dispositif (20).

14. Système basé sur ordinateur pour optimiser une lecture audio, le système comprenant :
un support de stockage (21) comprenant une pluralité d'éléments de contenu médiatique (22), au moins un vecteur (2) de caractéristiques associé à chacun desdits éléments de contenu médiatique (22), chaque vecteur (2) de caractéristiques comprenant une pluralité de valeurs de caractéristiques (3), chacune parmi ladite pluralité de valeurs de caractéristiques (3) représentant une caractéristique sémantique de l'élément de contenu médiatique (22) respectif ;
au moins un capteur auxiliaire (28) disposé dans un dispositif (20) et configuré pour générer un signal (11) de capteur comprenant des informations concernant au moins un(e) parmi niveau de bruit, température, emplacement, accélération, éclairage, type dudit dispositif (20), système d'exploitation fonctionnant sur ledit dispositif (20), ou données biométriques d'un utilisateur (30) dudit dispositif (20) ;
une base de données (17) comprenant un ensemble de règles (6) définissant des relations logiques entre au moins lesdites valeurs de caractéristiques (3), ledit signal (11) de capteur et certaines plages de fréquences d'un profil de réponse en fréquence (4) respectivement ;
un processeur (23) de signal audio configuré pour extraire un signal audio (1) d'un élément de contenu médiatique (22) ;
un processeur (25) configuré pour déterminer au moins un profil de réponse en fréquence (4) pour ledit signal audio (1) sur la base dudit au moins un vecteur (2) de caractéristiques associé et dudit signal (11) de capteur, en utilisant ledit ensemble de règles (6) ;
un égaliseur (24) de signal audio configuré pour produire un signal audio égalisé (7) sur la base d'un signal audio (1) et d'au moins un profil de réponse en fréquence (4), conformément aux étapes de procédé selon l'une quelconque des revendications 1 à 13 ; et
une interface audio (26) configurée pour lire le signal audio égalisé (7).

15. Support non transitoire lisible par ordinateur, stockant des instructions qui, lorsqu'elles sont exécutées par un processeur (25) d'un système basé sur ordinateur selon la revendication 14, amènent le processeur (25) à effectuer un procédé selon l'une quelconque des revendications 1 à 13.
